(19) Europäisches Patentamt / European Patent Office / Office européen des brevets

(11) **EP 2 786 105 B1**

(12) **FASCICULE DE BREVET EUROPEEN**

(45) Date de publication et mention
de la délivrance du brevet:
**09.06.2021 Bulletin 2021/23**

(51) Int Cl.:
*G01J 5/02* *(2006.01)*      *G01J 5/08* *(2006.01)*
*G01J 5/20* *(2006.01)*      *G02B 5/18* *(2006.01)*

(21) Numéro de dépôt: **12806558.8**

(22) Date de dépôt: **23.11.2012**

(86) Numéro de dépôt international:
**PCT/FR2012/052708**

(87) Numéro de publication internationale:
**WO 2013/079855 (06.06.2013 Gazette 2013/23)**

(54) **DETECTEUR INFRAROUGE A BASE DE MICRO-PLANCHES BOLOMETRIQUES SUSPENDUES**

INFRAROTDETEKTOR AUS SUSPENDIERTEN BOLOMETRISCHEN MIKROPLATTEN

INFRARED DETECTOR MADE UP OF SUSPENDED BOLOMETRIC MICRO-PLATES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.11.2011 FR 1160895**

(43) Date de publication de la demande:
**08.10.2014 Bulletin 2014/41**

(73) Titulaire: **Commissariat à l'Énergie Atomique
et aux Énergies Alternatives
75015 Paris (FR)**

(72) Inventeurs:
• **BOUTAMI, Salim**
**F-38100 Grenoble (FR)**
• **DUMONT, Geoffroy**
**F-75011 Paris (FR)**
• **HAZART, Jérôme**
**F-38320 Eybens (FR)**
• **YON, Jean-Jacques**
**F-38360 Sassenage (FR)**

(74) Mandataire: **Cabinet Laurent & Charras
Le Contemporain
50 Chemin de la Bruyère
69574 Dardilly Cedex (FR)**

(56) Documents cités:
**EP-A1- 1 116 942      EP-A2- 0 902 484
EP-A2- 1 243 903      WO-A2-2011/106553
US-A1- 2004 053 435**

## Description

## DOMAINE DE L'INVENTION

L'invention a trait au domaine de la détection bolométrique infrarouge ou térahertz, et plus particulièrement au domaine de la détection bolométrique à l'aide d'une matrice de micro-planches suspendues au dessus d'un substrat.

## ETAT DE LA TECHNIQUE

Comme il est communément admis, la détection infrarouge, au sens large, c'est-à-dire dans une gamme de longueurs d'onde comprises entre 0,75 micromètre et 1000 micromètres, est un domaine technologique soumis à des problématiques particulières. En effet, tout objet émet dans le spectre infrarouge dès lors que sa température est supérieure à 0°K. Ainsi, lorsque l'environnement d'un détecteur infrarouge est non refroidi, les organes entourant les éléments sensibles (substrats, connectiques, boitiers, optiques, etc...) émettent un rayonnement infrarouge significatif venant s'ajouter au rayonnement issu de la scène que l'on cherche à détecter. Cette composante non utile peut être très importante et parfois constituer un signal supérieur à celui que l'on veut mesurer. A cela s'ajoute un signal d'obscurité qui résulte par exemple de la génération thermique de porteurs dans le cas d'une photodiode IR, ou de la loi d'Ohm dans le cas d'un bolomètre. Cette composante non utile est communément désignée sous l'expression de « bruit thermique » ou de « mode commun ».

Par conséquent, et contrairement à d'autres types de détection, et notamment la détection visible, il est nécessaire de prévoir des structures et des fonctionnements sachant gérer de manière efficace ce mode commun. A cet effet, les premiers détecteurs infrarouges à haute sensibilité étaient refroidis à des températures très basses, de l'ordre de la centaine de degrés Kelvin, voire même quelques degrés Kelvin, afin de minimiser le mode commun.

Par ailleurs, il existe deux classes distinctes de détecteurs infrarouge, à savoir les détecteurs dit « quantiques » et les détecteurs dit « thermiques », et notamment pour cette dernière catégorie, les détecteurs thermiques bolométriques. Comme cela est également bien connu, les principes physiques mis en œuvre par ces deux types de détection sont fondamentalement différents et induisent leur propre problématique.

Dans le cas des détecteurs quantiques, un semi-conducteur est utilisé pour produire des paires électron-trou sous l'effet de l'absorption de photons dans le spectre infrarouge, les porteurs de charges ainsi créés étant collectés via des électrodes, le plus souvent combinées à une jonction de type PN.

Au contraire, dans le cas des détecteurs thermiques bolométriques, on met en œuvre un matériau absorbant choisi pour sa capacité à convertir la puissance du flux infrarouge incident en chaleur. Ce matériau, ou un second matériau en contact avec le premier matériau, est également utilisé pour convertir la chaleur produite en une variation d'une caractéristique électrique, généralement une variation de résistance électrique. La variation de la caractéristique électrique est ensuite mesurée.

Dans le but d'améliorer la sensibilité du détecteur, il a été conçu une architecture particulière de détecteur bolométrique, à savoir un détecteur qui comporte une matrice de micro-planches bolométriques suspendue au dessus d'un substrat dit « de lecture » à l'aide d'éléments de soutien et d'isolation thermique.

Comme cela est connu en soi, cette architecture est spécifiquement prévue pour isoler thermiquement les éléments bolométriques du substrat. Ce faisant, on obtient d'une part un gain important en termes de sensibilité, et d'autre part cette architecture permet également de s'affranchir de la mise en œuvre d'un refroidissement à très basse température.

Si une architecture à base de micro-planches suspendues présente de nombreux avantages, et tout particulièrement la possibilité d'être utilisée sans refroidissement à de très basses températures, la présence des éléments de soutien des micro-planches bolométriques ne permet pas d'obtenir un facteur de remplissage satisfaisant à l'aide des techniques courantes de fabrication, le facteur de remplissage étant d'autant plus mauvais que la miniaturisation des micro-planches est élevée.

Des solutions ont été développées pour augmenter le facteur de remplissage. Cependant, ces dernières impliquent une complexification des procédés de fabrication et corollairement, des coûts plus élevés.

Par exemple, le document US-A-6 094 127 décrit un détecteur à trois étages superposés avec notamment un étage comportant un circuit intégré, un étage de support et un étage d'absorption. L'étage d'absorption peut ainsi occuper la totalité de la surface du détecteur améliorant ainsi le rendement. Cependant, afin de connecter électriquement l'étage d'absorption à l'étage de support, un élément d'interconnexion électrique est intercalé entre les étages de support et d'absorption. Cet élément d'interconnexion électrique est constitué d'un canal conducteur enrobé dans une gaine diélectrique. Il en résulte un procédé de fabrication complexe et mettant directement en jeu la continuité électrique d'un étage à l'autre du détecteur, continuité qui est pourtant un élément crucial pour le fonctionnement optimal du détecteur. De plus, la présence de l'élément d'interconnexion électrique en contact avec l'étage d'absorption peut détériorer la qualité d'absorption et la sensibilité du détecteur.

Par ailleurs, afin d'augmenter le volume de production et/ou afin de réduire les coûts de fabrication, des procédés de fabrication collective sont usuellement mis en œuvre, plusieurs matrices de micro-planches étant fabriquées conjointement sur une même tranche de silicium (« *wafer* »), puis individualisées, comme cela est par exemple décrit dans les documents US-A-6 753 526 et US-A-6 924 485.

Etant donné que des procédés de fabrication collective sont déjà employés pour fabriquer les matrices de micro-planches, des procédés de fabrication collective issus de la micro électronique sont également employés pour réaliser des détecteurs intégrant directement un packaging sous vide pour chaque micro-planche, comme cela est par exemple décrit dans les deux derniers documents susmentionnés. Ce packaging, communément appelé « *micro-packaging hermétique intégré* », est constitué d'une capsule réalisée au dessus de chaque micro-planche et prenant appui sur le substrat de chaque côté de celle-ci et scellée hermétiquement sous vide. La réalisation collective des étapes de packaging permet ainsi de réduire les temps et les coûts de production des détecteurs par rapport à un seul boitier hermétique réalisé individuellement pour chaque matrice de micro-planches.

Cependant, l'espace nécessaire entre chaque micro-planche pour l'appui des capsules se traduit, à taille de matrice égale, par une baisse significative de la surface optiquement active du détecteur, et donc par une baisse directe du rendement du détecteur.

Ainsi donc, par construction, la surface utile d'une micro-planche bolométrique suspendue par des éléments de soutien, dédiée à la détection d'un rayonnement infrarouge ou térahertz est limitée par rapport à la surface de substrat, ce qui réduit la sensibilité du détecteur.

Par exemple, la réalisation de détecteurs avec des micro-planches carrées de 12 micromètres de côté, dimensions qui constituent à l'heure actuelle le degré maximum de miniaturisation des micro-planches bolométriques, et absorbant autour de $\lambda = 10\ \mu m$, nécessite pour chaque micro-planche une surface de substrat carrée d'au moins 17 micromètres de côté. La surface utile d'une matrice de micro-planches de 12 micromètres de côté, dédiée à la détection, représente donc au plus 50% de la surface totale de la matrice.

L'utilisation d'un substrat comprenant des micro-lentilles et rapporté sur un dispositif à base de micro-planches bolométriques afin de mieux collecter et focaliser la lumière sur les micro-planches est connu de EP0902484 A2.

## EXPOSE DE L'INVENTION

Le but de la présente invention est de résoudre le problème susmentionné de sensibilité réduite en raison d'une surface utile réduite dans des détecteurs bolométriques à base de micro-planches suspendues.

A cet effet, l'invention a pour objet un détecteur bolométrique matriciel pour la détection d'un rayonnement électromagnétique dans une gamme prédéterminée de longueurs d'onde infrarouge ou térahertz, comprenant :

- un substrat ; et
- une matrice de micro-planches bolométriques pour la détection dudit rayonnement, suspendues au dessus du substrat à l'aide d'éléments de soutien.

Selon l'invention :

- le détecteur comporte une membrane sensiblement transparente au rayonnement à détecter, ayant un premier indice de réfraction, disposée au dessus de chaque micro-planche, et dans laquelle sont formés des motifs, de second indice de réfraction inférieur au premier indice de réfraction, sur au moins une partie de l'épaisseur de la membrane ;
- les motifs de la membrane sont placés périodiquement dans celle-ci, le long d'au moins un axe prédéterminé, selon une période inférieure ou égale à $\dfrac{\lambda}{n}$, où A est *n* une longueur d'onde de la gamme de longueurs d'onde à détecter et *n* est l'indice de réfraction moyen du milieu séparant la micro-planche de la membrane ; et
- la largeur des motifs selon le ou chaque axe prédéterminé augmente depuis un emplacement de la membrane, positionné au dessus d'une zone centrale de la micro-planche, en direction de la périphérie de la membrane.

En outre, la membrane repose sur une couche de support au moins partiellement transparente au rayonnement à détecter et dont l'épaisseur vérifie sensiblement la relation $h_2 = \dfrac{m \times \lambda}{2 \times n_2}$, où $h_2$ est ladite épaisseur, $n_2$ est l'indice de réfraction de la couche de support, et *m* est un entier positif supérieur ou égal à 1, la couche de support présentant des parois latérales de soutien et la membrane reposant sur la couche de support et s'étendant dans un évent de libération de ladite couche de support de sorte que ladite couche de support forme avec ses parois latérales de soutien et la membrane, une enceinte hermétique dans laquelle est au moins positionné un ensemble d'au moins une micro-planche comportant ladite micro-planche.

En d'autres termes, l'invention est la combinaison de plusieurs caractéristiques physiques qui induisent ensemble un phénomène de focalisation, à savoir :

- une membrane transparente au rayonnement à détecter ;
- une alternance de matériaux de différents indices de réfraction (matériau de la membrane et matériau des motifs réalisés dans la membrane) définie par une périodicité plus faible que le rayonnement à détecter, et qui est par conséquent, du point de vue du rayonnement, une couche d'indice effectif de réfraction homogène par morceau ; et

- un gradient d'indice effectif de réfraction dans le plan de la membrane, l'indice effectif de réfraction diminuant à mesure que l'on s'éloigne du « centre » de la membrane (ou tout autre endroit considéré comme tel vis-à-vis de la micro-planche), du fait de l'augmentation de la taille des motifs. Par exemple, en considérant une augmentation constante de la taille des motifs, un profil hyperbolique d'indice effectif est obtenu dans le plan de la membrane selon chaque axe de périodicité.

Ainsi pour un front d'onde plan incident sur la membrane, la lumière traversant celle-ci est de plus en plus ralentie à mesure que l'on se rapproche du centre de la membrane puisque l'indice effectif de réfraction augmente vers le centre. Le front d'onde en sortie de la membrane est donc courbé de façon convexe. La membrane selon l'invention se comporte donc de manière analogue à une lentille convergente classique pour le rayonnement à détecter. Le rayonnement incident sur la membrane est donc concentré sur la micro-planche. Notamment, comme la membrane s'étend au-delà de la micro-planche, une partie du rayonnement incident sur la portion de membrane qui n'est pas à l'aplomb de la micro-planche est « redirigée » vers celle-ci. La surface utile dédiée à la détection du rayonnement est donc augmentée, et corollairement, la sensibilité globale du détecteur est optimisée. En outre, cet effet est obtenu sans que le ratio entre la surface des micro-planches et la surface totale de la matrice de micro-planche ne soit sensiblement modifié. Dans la description qui suit, et comme il est usuellement admis dans le domaine, le terme pixel, lorsqu'il se réfère à la matrice de détection, se comprend comme l'ensemble des éléments matériels produisant un signal de sortie relatif à un point d'image, ainsi qu'à la surface dédiée à ces éléments.

De plus, la couche de support permet notamment de renforcer la membrane. En choisissant son épaisseur selon la relation ci-dessus, la couche de support est neutre optiquement, le rayonnement en sortie de la membrane se comportant sensiblement comme si la couche de support n'existait pas.

La couche de support est une couche mince réalisée au moyen de technique de dépôt, de photolithographie ou de gravure. La couche de support présente une épaisseur mince, de préférence inférieure à 10 micromètres.

Selon un mode de réalisation de l'invention, la période des motifs est sensiblement égale à $\dfrac{\lambda}{4 \times n}$. Cette valeur est un bon compromis entre la propriété sub-longueur d'onde du pas des motifs de la membrane, qui permet de définir un indice effectif de réfraction homogène pour le rayonnement, et la simplicité de fabrication des motifs.

Plus particulièrement, la largeur des motifs audit emplacement de la membrane vérifie la relation $\dfrac{W_0}{P} \leq 0,5$ , où $W_0$ est la largeur audit emplacement et $P$ la période selon l'axe prédéterminé. Cette valeur permet d'obtenir des motifs de faible largeur au centre, et de largeur plus importante vers l'extérieur, tout en tenant compte des contraintes technologiques qui limitent généralement la dimension des motifs qu'il est possible d'obtenir.

Préférentiellement, l'écart entre les largeurs de deux motifs adjacents est inférieur ou égal à $\dfrac{\lambda}{10 \times n}$. De cette manière, la variation de l'indice de réfraction est régulière du point de *10xn* vue du rayonnement à détecter.

Selon un mode de réalisation de l'invention, l'épaisseur de motifs est supérieure ou égale à $\dfrac{\lambda}{10 \times n}$.

La différence de déphasage du rayonnement en sortie de la membrane entre le centre et le bord de celle-ci dépend notamment de l'épaisseur de la membrane, puisque le déphasage maximum $\Delta\varphi_{\mathrm{max}}$ satisfait la relation $\Delta\varphi_{\mathrm{max}} = \dfrac{2\pi}{\lambda}\left(n_h - n_b\right) \times h_1$, où $n_h$ et $n_b$ sont respectivement les indices de réfraction de la membrane et des motifs, et $h_1$ est l'épaisseur des motifs. En choisissant une épaisseur $h_1$ supérieure ou égale à $\dfrac{\lambda}{10 \times n}$, on obtient donc un déphasage important permettant une focalisation élevée.

Selon un mode de réalisation, $m$ est égal à 1

Selon une variante de l'invention, les motifs de la membrane sont également réalisés dans la couche de support, au moins sur une partie de l'épaisseur de celle-ci.

Selon un mode de réalisation, les motifs remplissent hermétiquement des ouvertures formées dans la membrane, et en ce que la membrane forme, avec des parois latérales de soutien, une enceinte hermétique dans laquelle est positionné un ensemble d'au moins une micro-planche comportant la micro-planche. La membrane fait ainsi partie d'un micro-packaging tout en réalisant également sa fonction de focalisation.

Notamment, l'enceinte hermétique est une enceinte individuelle ne comportant qu'une micro-planche.

Selon un mode de réalisation, les motifs sont des ouvertures pratiquées dans la membrane et remplies d'un gaz, notamment de l'air, ce qui permet d'assurer un fort contraste d'indice entre les matériaux de la membrane et des motifs, puisque l'indice de réfraction d'un gaz est généralement proche de l'unité. Une focalisation élevée est ainsi obtenue.

Selon un mode de réalisation de l'invention, la membrane est soutenue par une structure prenant appui sur au moins une partie des éléments de soutien de la micro-planche, ce qui réduit l'encombrement de la structure de soutien de la membrane.

Selon un mode de réalisation, les motifs de la membrane sont des bandes parallèles, de sorte que la détection par la texturation est sensible à une seule polarisation.

En variante, il existe plusieurs axes le long desquels il existe un gradient d'indice effectif décroissant depuis le centre vers le bord de la membrane. Notamment, les motifs de la membrane sont carrés ou circulaires. De cette manière, la détection par la texturation est insensible à la polarisation du rayonnement incident.

Selon un mode de réalisation, la membrane est constituée de germanium, de silicium ou d'un alliage de ceux-ci. Ces matériaux sont en effet transparents dans la gamme de longueurs d'onde infrarouge.

En variante, la membrane est constituée d'oxyde de silicium SiOx, de SiON ou de SiN, ou d'un alliage de ceux-ci. Ces matériaux sont en effet transparents dans la gamme térahertz.

L'invention a également pour objet un procédé de fabrication d'un détecteur bolométrique du type précité, comprenant la réalisation d'une matrice de micro-planches bolométriques suspendues au-dessus d'un substrat à l'aide d'éléments de soutien, la réalisation de la matrice de micro-planches comportant le dépôt d'une première couche sacrificielle sur le substrat et le dépôt des micro-planches sur la première couche sacrificielle.

Selon l'invention, le procédé comporte :

- le dépôt, sur la première couche sacrificielles et les membranes bolométriques, d'une seconde couche sacrificielle ;
- le dépôt, sur la deuxième couche sacrificielle, d'une couche de support au moins partiellement transparente au rayonnement à détecter, et dont l'épaisseur vérifie sensiblement la relation

$$h_2 = \frac{m \times \lambda}{2 \times n_2},$$

où $h_2$ est ladite épaisseur, $n_2$ est l'indice de réfraction de la couche de support, et $m$ est un entier positif supérieur ou égal à 1 ;
- le dépôt, sur la couche de support et au-dessus de chaque micro-planche, d'une couche sensiblement transparente au rayonnement à détecter ayant un premier indice de réfraction ;

- la réalisation sur au moins une partie de l'épaisseur de chaque couche disposée au-dessus d'une micro-planche, de motifs de second indice de réfraction inférieur au premier indice de réfraction, les motifs étant placés périodiquement dans celle-ci, le long d'au moins un axe prédéterminé, selon une période inférieure ou égale à $\frac{\lambda}{n}$, où $\lambda$ est une longueur d'onde de la gamme de longueurs d'onde à détecter et $n$ est l'indice de réfraction moyen d'un milieu séparant la micro-planche de la couche une fois les première et seconde couches sacrificielles retirées, et la largeur des motifs selon le ou chaque axe prédéterminé augmentant depuis un emplacement de la couche, positionné au-dessus d'une zone centrale de la micro-planche, en direction de la périphérie de la couche ; et

- le retrait des première et seconde couches sacrificielles.

Selon un mode de réalisation, la réalisation des motifs comporte la gravure de la couche dans la totalité de l'épaisseur de celle-ci, et en ce que la couche de support et la gravure sont choisies de manière à obtenir une gravure sélective de la couche.

Ainsi, la couche de support forme une couche d'arrêt lors de la réalisation des motifs par gravure de la couche membrane.

Notamment, le dépôt de la couche de support comporte le dépôt d'une première couche de matériau oxydable et une étape d'oxydation de la surface libre de la couche de support de manière à obtenir une couche d'oxyde.

## BREVE DESCRIPTION DES FIGURES

La présente invention sera mieux comprise à la lecture de la description qui va suivre, donnée uniquement à titre d'exemple, et réalisée en relation avec les dessins annexés, dans lesquels des références identiques désignent des éléments identiques ou analogues, et dans lesquels :

- la figure 1 est une vue schématique de dessus d'une matrice de trois pixels bolométriques par trois pixels bolométriques pourvus de membranes focalisatrices selon un exemple de réalisation non couvert par les revendications ;
- la figure 2 est une vue schématique en section de la matrice de la figure 1 selon la section A-A;
- la figure 3 est une vue schématique simplifié en section d'une membrane selon la figure 1 ;
- la figure 4 est un profil de l'indice de réfraction effectif de la membrane de la figure 1 selon un axe de périodicité des motifs de celle-ci ;
- la figure 5A est une cartographie de l'intensité du champ électromagnétique en présence d'une membrane focalisatrice dans un plan normal à celle-ci ;
- la figure 5B est un tracé de courbes d'absorption dans une micro-planche en TiN en présence ou en l'absence de la membrane focalisatrice ;
- la figure 6 est une vue de dessus d'un autre mode de réalisation de la membrane focalisatrice ;

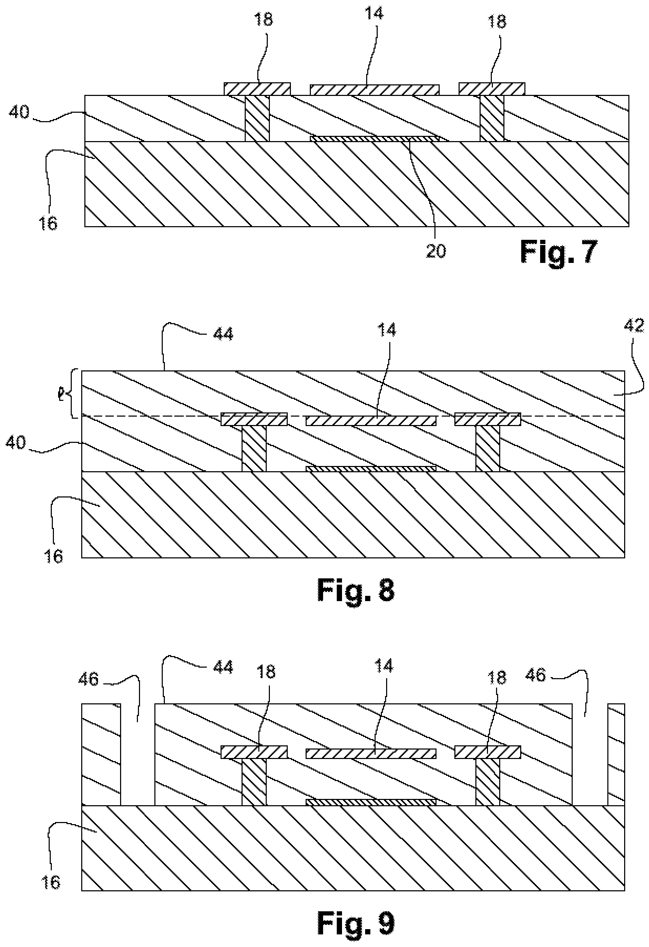

■ les figures 7 à 12 sont des vues schématiques en coupe illustrant un procédé de fabrication d'une structure de soutien de membrane focalisatrice selon un exemple de réalisation de l'invention non couvert par les revendications ;

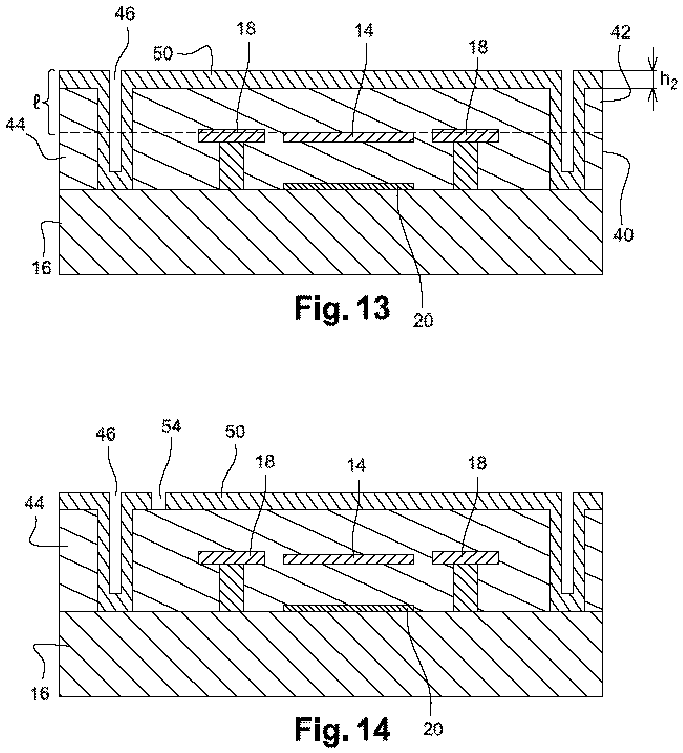

■ les figures 13 à 19 sont des vues schématiques en coupe illustrant un procédé de fabrication d'une structure de soutien de membrane focalisatrice avec un micro-packaging hermétique selon un premier mode de réalisation de l'invention ;

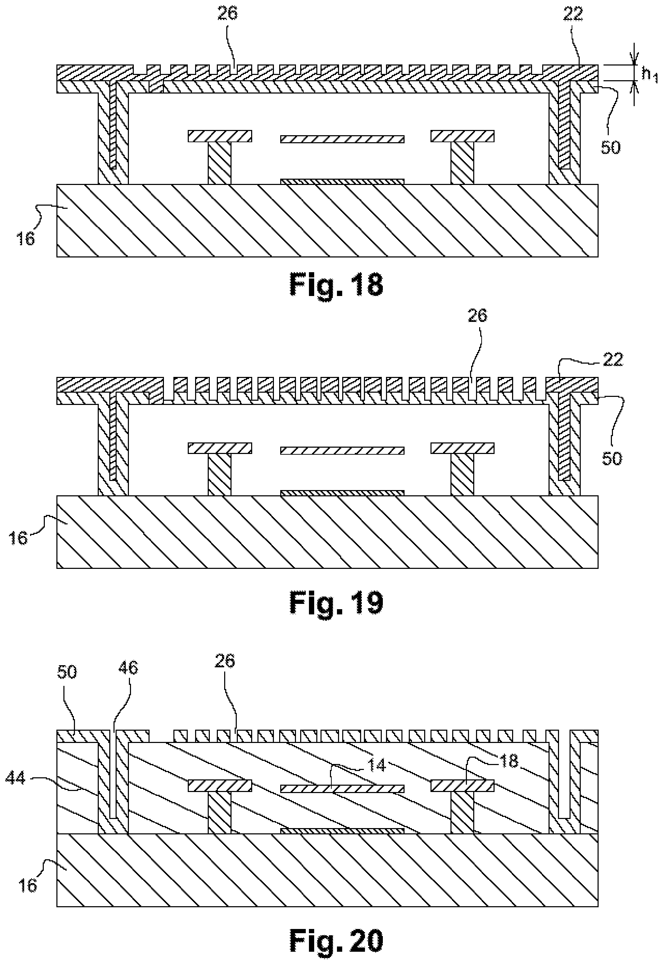

■ les figures 20 à 22 sont des vues schématiques en coupe illustrant une variante du procédé de fabrication d'une structure de soutien de membrane focalisatrice avec un micro-packaging hermétique ;

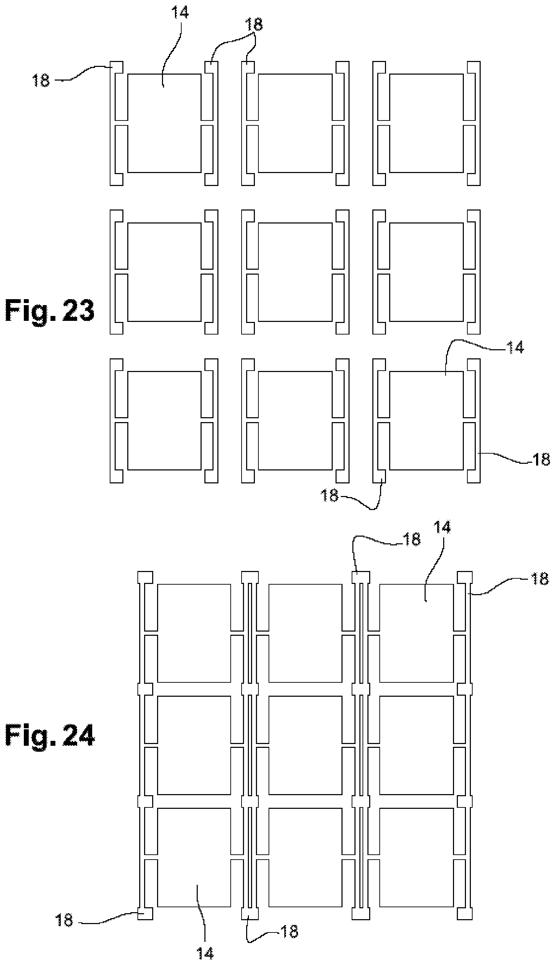

■ les figures 23 et 24 sont respectivement des vues de dessus d'une matrice de micro-planches avec des éléments de soutien individuels et d'une matrice de micro-planches avec des éléments de soutien communs ;

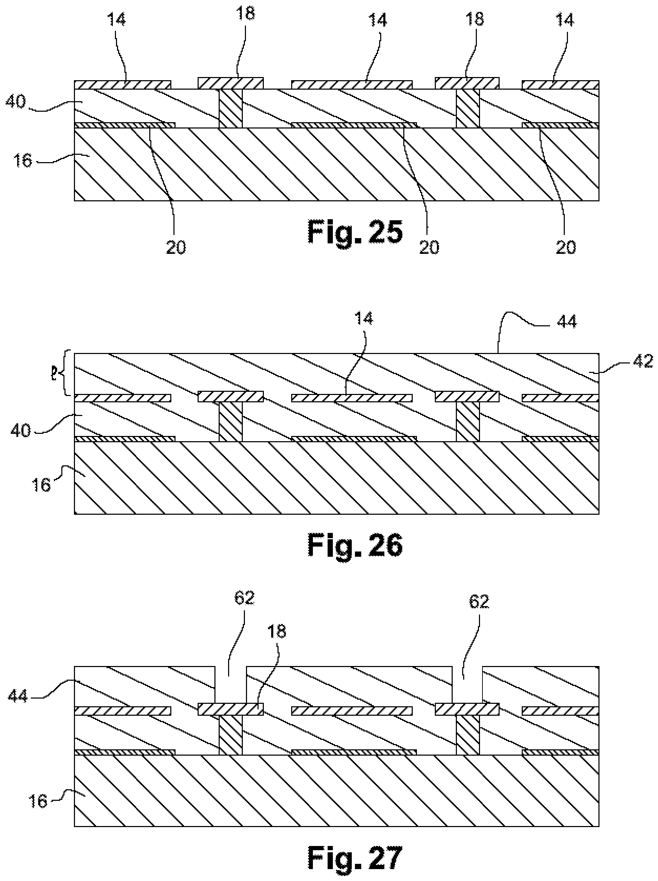

■ les figures 25 à 30 sont des vues schématiques en coupe illustrant un procédé de fabrication d'une structure de soutien de membrane focalisatrice selon un exemple de réalisation non couvert par les revendications ; et

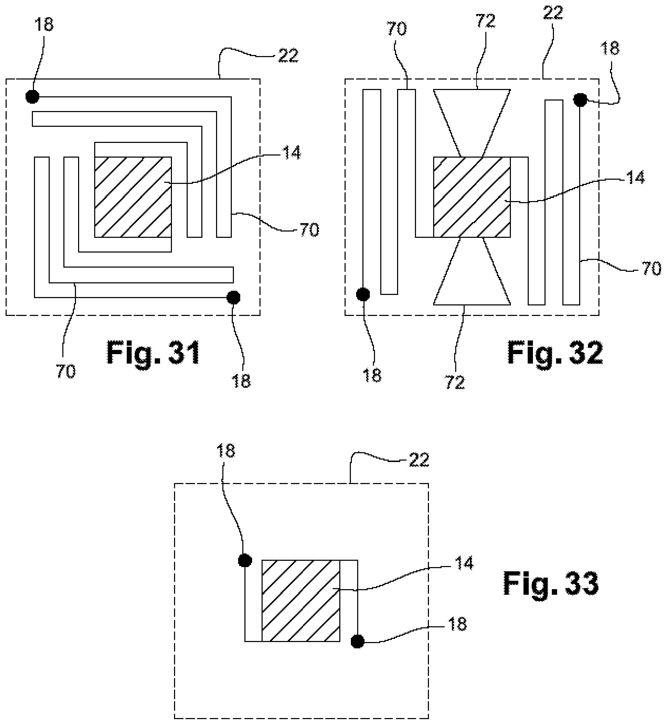

■ les figures 31 à 33 sont des vues schématiques de dessus illustrant l'utilisation d'un accroissement de surface d'un pixel, respectivement pour un rallongement des éléments d'isolation thermique d'une micro-planche bolométrique, l'intégration d'une antenne térahertz et la mise en œuvre de fonction supplémentaire dans un substrat.

## DESCRIPTION DETAILLEE DE L'INVENTION

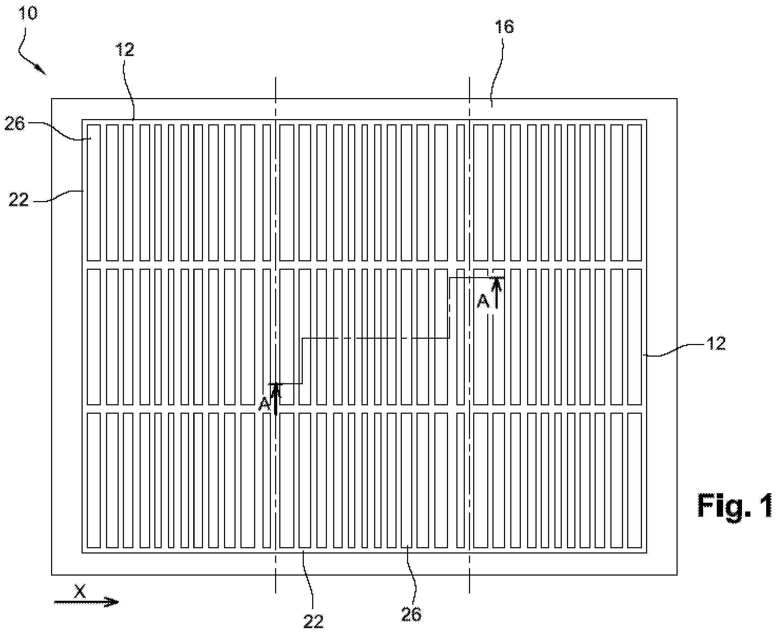

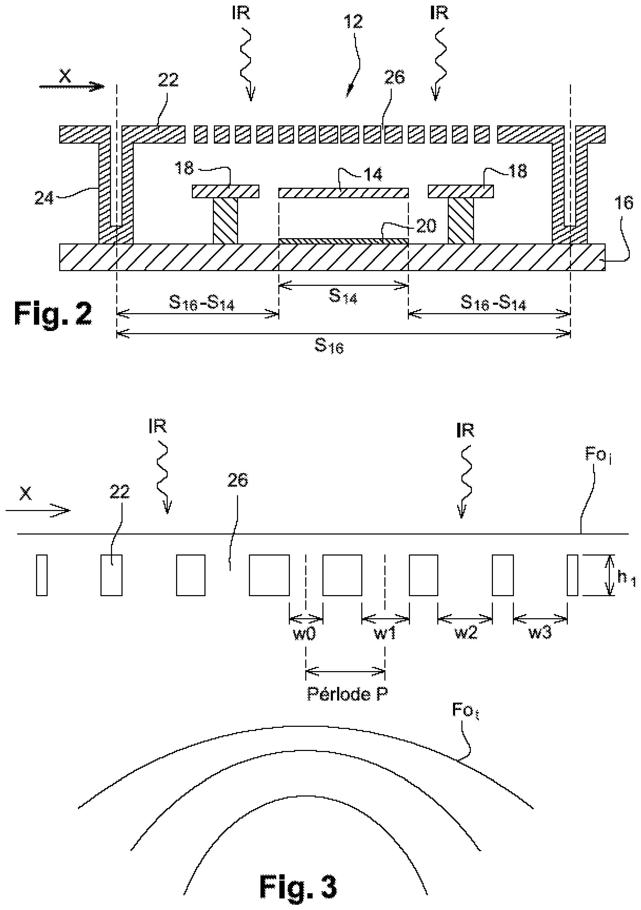

En se référant aux figures 1 et 2, il est illustré à titre d'exemple une matrice de détection bolométrique **10** de trois pixels par trois pixels.

Chaque pixel **12** comporte une micro-planche bolométrique **14,** suspendue au-dessus d'un substrat **16** par des éléments de soutien et d'isolation thermique **18,** et permettant la détection d'un rayonnement électromagnétique incident « *IR* » dans une gamme de longueurs d'onde infrarouge comprises entre 0,75 micromètre et 100 micromètres et/ou dans une gamme de longueurs d'onde térahertz comprises entre 100 micromètres et 3 millimètres.

Comme cela est connu en soi, la micro-planche **14** s'échauffe sous l'action du rayonnement incident *IR* et voit sa résistance électrique varier en fonction de son échauffement. Un même matériau peut être utilisé pour mettre en œuvre ces deux fonctions, comme du silicium par exemple, qui est adapté à la détection des longueurs d'onde dans l'infrarouge moyen.

Les éléments de soutien et d'isolation thermique **18** sont, quant à eux, constitués majoritairement d'un matériau peu conducteur de la chaleur, mais comportent un élément conducteur électrique permettant de soumettre la micro-planche **14** à une tension et/ou un courant de polarisation pour la mesure de sa résistance électrique. Les éléments de soutien **18** sont électriquement connectés à un circuit de lecture agencé dans le substrat **16** qui pilote la polarisation de la micro-planche **14.**

Chaque pixel **12** comporte par ailleurs un réflecteur plan **20** formé à partir d'une couche de métal déposée sur le substrat **16,** et disposée sous la microplanche **14.** Le réflecteur **20** a pour fonction de réfléchir la portion de rayonnement ayant traversé la micro-planche **14** sans être absorbée, permettant ainsi au moins un double passage du rayonnement dans la micro-planche, voire un phénomène de résonnance lorsque la distance entre la micro-planche **14** et le réflecteur **20** est réglée par exemple de manière à former une lame quart d'onde.

Dans le cadre de l'invention, la structure et le fonctionnement des micro-planches bolométriques **14** importent peu, n'importe quel type de micro-planche pouvant être envisagé, comme par exemple celui décrit dans le document FR 2 752 299. On retiendra seulement que l'invention s'applique à toute matrice bolométrique, dont la surface des micro-planches est réduite vis-à-vis de la surface des pixels.

Avantageusement, chaque pixel **12** comporte également une membrane focalisatrice **22** transparente au rayonnement à détecter, suspendue au dessus de la micro-planche **14** par une structure de soutien **24** qui est formée sur le substrat **16** sensiblement à mi-distance entre le pixel **12** et les pixels adjacents à celui-ci. La membrane focalisatrice **22** est par exemple constituée de germanium, de silicium ou d'un alliage de ceux-ci, ces matériaux étant transparents au rayonnement infrarouge et donc adaptés à une détection infrarouge, ou en SiOx, en SiON ou en SiN, ces matériaux étant transparents au rayonnement térahertz, et donc adaptés à une détection térahertz.

Dans l'exemple illustré, la micro-planche **14** et la membrane **22** sont rectangulaires et centrées l'une sur l'autre.

La structure de soutien **24,** par exemple sous la forme de parois latérales, entoure la micro-planche **14,** les éléments de soutien ainsi que la surface $S_{16}$ du substrat **16** dédiée au pixel **12,** de sorte que la membrane **22** recouvre sensiblement toute la surface du pixel **12.** Notamment, la membrane **22** recouvre sensiblement la majeure partie de, ou toute, la surface $S_{16}$-$S_{14}$ du pixel **12** non couverte par la micro-planche **14.**

La membrane **22** comporte par ailleurs un ensemble de fentes rectilignes parallèles à section rectangulaire, réalisées sur toute la largeur de la membrane **22,** les fentes **26** étant agencées pour focaliser sur la micro-planche **14** un rayonnement *IR* incident sur la membrane **22,** et notamment le rayonnement incident sur la portion de membrane **22** qui n'est pas disposée au dessus de la micro-planche **14.**

Comme cela est connu en soi, la micro-planche **14** est thermiquement isolée de son environnement et est à cet effet suspendue dans un gaz, par exemple de l'air ou un gaz neutre, le plus souvent sous une pression réduite. La membrane **22** est donc également suspendue dans ce gaz, et comme un gaz présente un indice de réfraction proche de l'unité, les fentes **26** définissent dans la membrane **22** des motifs d'indice de réfraction inférieur à l'indice de réfraction du matériau constitutif de la membrane **22.**

En se référant à la figure 3, les fentes **26** sont régulièrement placées selon la direction *X* perpendiculaire à celles-ci, les axes médians des fentes **26** étant positionnés selon une période *P* constante. Cette période, choisie en fonction d'une longueur d'onde Λ à focaliser sur la micro-planche **14,** est inférieure à $\frac{\lambda}{n}$, où *n* est l'indice de réfraction du milieu séparant la micro-planche **14** de la membrane **22.** La période *P* est de préférence sensiblement égale à $\frac{\lambda}{4 \times n}$, cette valeur constituant un compromis avantageux entre d'une part le fait que la période *P* doit être inférieure à la longueur d'onde λ/n, et d'autre part la facilité de fabrication des fentes, la fabrication étant usuellement de plus en plus difficile à mesure que la période diminue.

Par ailleurs, la largeur *W* des fentes **26** selon la direction *X* augmente depuis le centre de la membrane **22,** c'est-à-dire, dans l'exemple illustré, depuis l'emplacement de la membrane **22** à l'aplomb du centre de la micro-planche **14,** en direction de la périphérie de la membrane **22,** de manière à focaliser le rayonnement incident sur la membrane **22** dans un espace central sous la membrane **22,** ce qui permet d'augmenter la quantité de rayonnement « vue » par la micro-planche **14** et donc absorbée par celle-ci.

Avantageusement, l'écart $(W_{n+1} - W_n)$ entre les largeurs $W_n$ et $W_{n+1}$ de deux fentes adjacentes est inférieur ou égal à $\frac{\lambda}{10 \times n}$. De cette manière, la variation de l'indice effectif de réfraction est régulière du point de vue du rayonnement à détecter.

Avantageusement, l'augmentation de largeur à mesure que l'on s'éloigne du centre de la membrane **22** est constante, la largeur des fentes augmentant donc linéairement. Il est toutefois possible de prévoir une augmentation non linéaire de la largeur des fentes.

Avantageusement encore, la largeur $W_0$ de la fente centrale vérifie la relation $\frac{W_0}{P} \le 0,5$, et est de préférence sensiblement égale à $\frac{P}{2}$. On notera que la condition $\frac{W_0}{P}$ est sensiblement égale à P/2, ce qui permet de faciliter la fabrication des fentes en évitant des fentes trop fines à fabriquer. On notera cependant qu'il est possible de prévoir des valeurs de $\frac{W_0}{P}$ bien plus petites. Pour une période P égale à $\frac{\lambda}{4 \times n}$, la largeur $W_0$ est donc inférieure à $\frac{\lambda}{8 \times n}$, c'est-à-dire très faible comparativement au rayonnement à détecter. La largeur des fentes **26,** bien qu'augmentant depuis le centre vers la périphérie de la membrane **22,** reste donc faible par rapport à la longueur d'onde compte tenu de la valeur de l'incrément de largeur ($W_{n+1} - W_n$).

Avantageusement encore, l'épaisseur $h_1$ de la membrane **22,** et donc l'épaisseur des motifs constituées par les fentes **26,** est supérieure ou égale à $\frac{\lambda}{10 \times n}$.

Du fait de l'accroissement des fentes **26** du centre vers la périphérie de la membrane 22, il existe donc un gradient d'indice effectif de réfraction dans le plan de cette dernière selon la direction de périodicité.

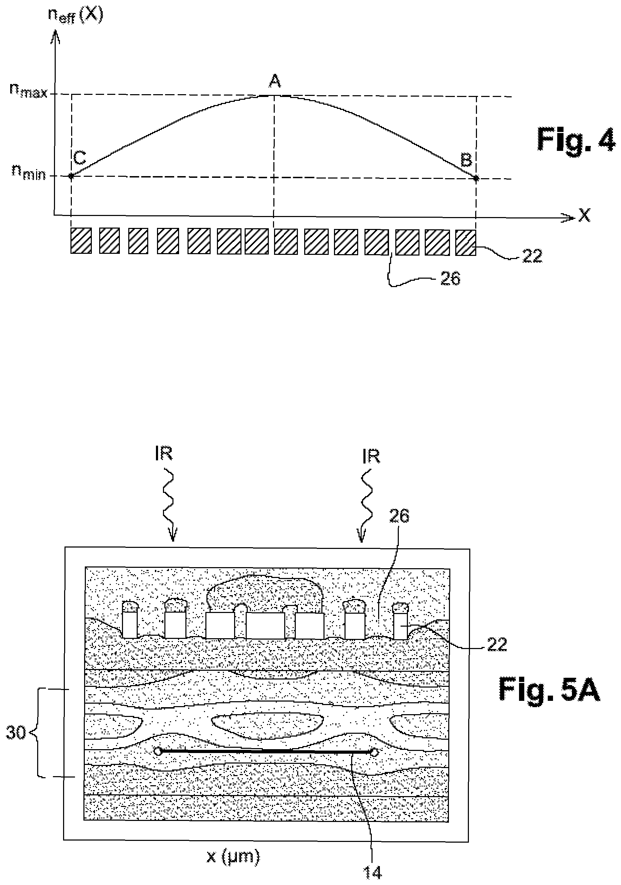

Un tel gradient est illustré à la figure 4 qui est un tracé de l'indice de réfraction effectif en fonction d'un axe des abscisses selon la direction X. L'indice effectif $n_{eff}$ est calculé en réalisant une moyenne de l'indice de réfraction $n_h$ du matériau constitutif de la membrane **22** et de l'indice de réfraction $n_b$ du matériau ou milieu remplissant les fentes **26,** les indices étant pondérés par le taux d'occupation des matériaux en cause, à savoir un indice effectif selon la relation $n_{eff} = \sqrt{f_b.(n_b^{\,2}) + (1-f_b).(n_h^{\,2})}$, où $f_b$ est la proportion locale de matériau ou milieu de bas indice $n_b$, à savoir dans le mode de réalisation, la largeur locale $w_i$ des fentes **26** divisée par la période *P.*

L'indice de réfraction effectif est donc maximal ($n_{max}$) au centre de la membrane **22** et est inférieur ou égal à l'indice de réfraction $n_h$ du matériau constitutif de la membrane **22,** et décroit pour atteindre une valeur minimale $n_{min}$ à la périphérie de celle-ci, cette valeur minimale étant supérieure ou égale à l'indice de réfraction $n_b$ du milieu remplissant les fentes **26.** La décroissance entre la valeur $n_{max}$ à la valeur $n_{min}$ dépend de la manière dont la largeur des fentes **26** croit. Dans le mode de réalisation décrit ci-dessus, dans lequel la croissance de la largeur des fentes **26** est constante, l'indice de réfraction effectif est une portion d'hyperbole.

En raison du gradient d'indice, le rayonnement traversant sur la membrane **22** subit un déphasage croissant à mesure que l'on s'approche du centre de la membrane **22.** Notamment, le déphasage $\varphi(x)$ subit par un front d'onde plan $FO_i$ incident sur la membrane **22** (figure 3) est égal au premier ordre à

$$\varphi(x) = \frac{2\pi}{\lambda} n_{eff}(x) \times h_1.$$

Le front d'onde $FO_t$ transmis par la membrane **22** est donc courbé de façon convexe, le rayonnement traversant plus rapidement la membrane à la périphérie qu'au centre. Il est ainsi obtenu une focalisation du rayonnement sous la membrane **22** et donc sur la micro-planche **14**.

De préférence, la membrane est agencée à une distance préférablement supérieure à $\frac{\lambda}{4n}$ de la micro-planche, l'intensité de la focalisation étant élevée pour de telles distances.

La figure 5A est une cartographie de l'intensité du champ électromagnétique en présence d'une membrane focalisatrice **22**, et dans un plan perpendiculaire à celle-ci selon la direction X, ladite membrane **22** étant éclairée par un rayonnement infrarouge dans la gamme 8 - 14 $\mu$m. Les abscisses représentent ladite direction X, le niveau de gris étant d'autant plus clair que l'intensité du champ électromagnétique est élevée, les paramètres du détecteur étant définis comme suit :

- la membrane **22** est réglée sur la longueur d'onde 11 $\mu$m :
- la période P est de 2,2 $\mu$m,
- la largeur $W_0$ de la fente centrale est égale à 0,4 $\mu$m,
- l'incrément de largeur ($W_{n+1} - W_n$) entre deux fentes voisines est égal à 400 nm, et
- l'épaisseur $h_1$ de la membrane **22** est égale à 1,25 $\mu$m ;
- l'épaisseur $h_2$ d'une couche de support de la membrane **22** en silicium de support égale à 1,4 $\mu$m;
- la largeur du pixel selon la direction X est de 17 $\mu$m, et
- la largeur de la micro-planche **14** selon cette même direction est de 12 $\mu$m, la micro-planche **14** et la membrane étant centrées l'une sur l'autre.

La membrane **22** et la micro-planche **14** sont placées dans l'air. La micro-planche **14** est ici représentée, à titre d'exemple, à une distance $l$ de la membrane **22** égale à 5,4$\mu$m du bas de la membrane **22**.

Comme cela est parfaitement visible sur la figure 5A, on observe un renforcement de l'intensité du champ électromagnétique infrarouge sous la membrane **22**, et notamment un renforcement maximum dans une zone centrale **30** sous la membrane 22.

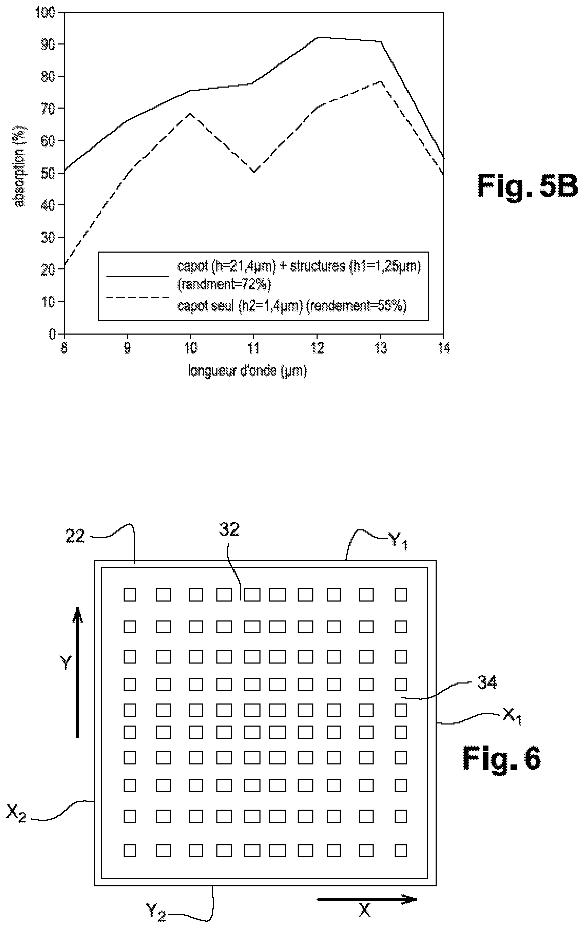

La figure 5B est un tracé de courbes d'absorption dans la micro-planche **14** en TiN dans la gamme 6 - 15 $\mu$m avec la membrane **22** décrite ci-dessus (courbe en trait plein) et sans la membrane (courbe en trait pointillé). Comme il est possible de le constater, on observe un renforcement sensible de l'absorption pour une large gamme de longueurs d'onde, ce renforcement étant proche de 30% du maximum du pic d'absorption.

Il a été décrit un mode de réalisation dans lequel des fentes rectilignes parallèles sont réalisées dans la membrane **22**, ce qui permet une sélectivité en polarisation de la focalisation mise en œuvre par la membrane **22**. Notamment, c'est la lumière polarisée perpendiculairement aux fentes dans le plan de la membrane **22** qui est focalisée.

Il peut cependant être souhaité que la focalisation soit appliquée à plusieurs polarisations de la lumière.

En variante, les motifs de la membrane focalisatrice **22** sont disposés régulièrement selon plusieurs directions différentes dans le plan de la membrane. Comme cela est par exemple illustré à la figure 6, deux réseaux de fentes croisées **32, 34** sont disposées régulièrement respectivement selon l'axe X et l'axe Y, les réseaux présentant un incrément de largeur identique. Un tel agencement permet une détection identique des polarisations de la lumière selon les axes X et Y. Bien entendu, d'autres configurations sont possibles en fonction des applications visées. Tout d'abord, la période selon l'axe X peut être différente de la période selon l'axe Y. De même, il est possible de prévoir un incrément de largeur selon l'axe X qui soit différent de celui de l'axe Y. De même, il est possible de prévoir des axes X et Y non perpendiculaires, et/ou des fentes selon un ou plusieurs axes supplémentaires. En variante également, il est possible de prévoir, en lieu et place des réseaux de fentes, des motifs rectangulaires, carrées, circulaires ou autres, pratiquées dans l'épaisseur de la membrane focalisatrice. Là encore, il est possible de définir des axes dans le plan de la membrane selon lesquels ces motifs sont régulièrement espacés avec des largeurs selon lesdits axes qui augmentent à mesure que l'on s'approche des bords de la membrane. De même, il est possible de définir des fentes formant des contours fermés concentriques, par exemple des contours fermés carrés, rectangulaires ou circulaires. Certains de ces agencements requièrent que la gravure de la membrane **22** soit partielle, ou bien la présence d'une couche de support, pour la tenue mécanique de la membrane **22**.

Il va à présent être décrit plusieurs modes de réalisation de la membrane, ainsi que des procédés de fabrication associé, notamment concernant la structure de suspension de la membrane focalisatrice.

Les figures schématiques en coupe 7 à 12 illustrent un procédé de fabrication d'un premier mode de réalisation de la structure de suspension.

Le procédé débute par la fabrication, sur le substrat **16**, de la matrice de micro-planches **14**, des éléments de soutien **18** et des réflecteurs **20**. Cette étape de fabrication est classique, et comme cela est connu en soi, les micro-planches **14** sont réalisées sur une couche sacrificielle **40** déposée sur le substrat **16** (figure 7).

Une fois les micro-planches **14** formées, le procédé se poursuit en déposant une deuxième couche sacrificielle **42** sur la première couche sacrificielle **40**, les micro-planches **14** et les éléments de soutien **18**. L'épaisseur de la deuxième couche **42** est égale à la distance *l* désirée entre la membrane focalisatrice **22** et la micro-planche **14** (figure 8). La deuxième couche **42** est, par exemple, déposée au moyen d'une technique de dépôt à la tournette (plus connu sous l'expression anglo-saxonne de « *spin coating* »), et est constituée avantageusement du même matériau que la première couche **40,** notamment un polyimide, un polymère par exemple à base de BCB (benzocyclobutène), une résine photosensible recuite ou autres. Les première et deuxième couches **40, 42** forment ensemble une couche sacrificielle globale **44.**

Une gravure de la couche sacrificielle **44** est alors réalisée jusqu'au substrat 16 pour dégager une tranchée **46** tout autour de chaque micro-planche **14** et de ses éléments de soutien **18** à l'emplacement souhaité pour la structure de soutien de la membrane focalisatrice, par exemple une tranchée formée à la limite de la surface de substrat **16** dédiée à la micro-planche **14** (figure 9). Les tranchées **46** sont avantageusement réalisées par gravure sèche par ions réactifs (ou gravure « RIE » pour « *reactive ion etching* »), qui permet une grande anisotropie de la gravure, ou bien par une chimie de gravure à base d'oxygène.

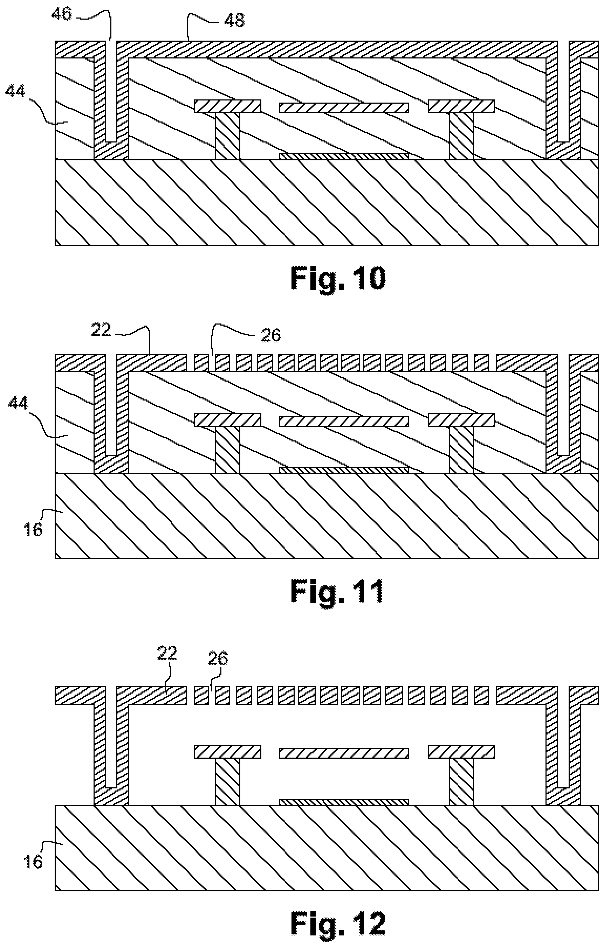

Un matériau transparent pour le rayonnement à détecter est alors déposé pleine plaque, de sorte que la couche sacrificielle **44** ainsi que les tranchées **46** sont recouvertes d'une couche **48** à partir de laquelle est ultérieurement formée la membrane focalisatrice (figure 10). Ce dépôt est préférentiellement réalisé au moyen d'un dépôt chimique en phase vapeur (ou dépôt « CVD » pour l'expression anglo-saxone « *Chemical Vapor Deposition* ») qui permet une bonne conformité du dépôt sur les flancs des tranchées **46.** La couche **48** est réalisée par exemple en germanium, en silicium ou en un alliage de ceux-ci pour une détection infrarouge, et en SiOx, en SiON ou en SiN pour une détection térahertz.

Une lithographie et une gravure, par exemple une gravure sèche du type RIE, sont ensuite mises en œuvre pour réaliser les ouvertures **26** dans la couche **48,** afin de former la membrane focalisatrice **22** de l'invention (figure 11). La lithographie et la gravure sont ici mises en œuvre de manière connue en soi.

Enfin, la couche sacrificielle **44** est retirée, par exemple au moyen d'un plasma d'oxygène ou d'ozone (figure 12).

Le mode de réalisation est avantageux dans la mesure où le nombre d'étapes de fabrication est minimal.

Un deuxième mode de réalisation de la structure de soutien et son procédé de fabrication sont décrits à présent en relation avec les figures schématiques en coupe 13 à 19, ce deuxième mode de réalisation permettant de fabriquer de manière conjointe une membrane focalisatrice et une capsule hermétique pour chaque micro-planche.

Ce procédé débute par les mêmes étapes que celles décrites en relation avec les figures 7 à 9, puis se poursuit par le dépôt pleine plaque d'un matériau semi-conducteur ou diélectrique, de sorte que la couche sacrificielle **44** et les tranchées **46** sont recouvertes d'une couche **50** dudit matériau (figure 13). A la différence toutefois du mode de réalisation précédent, l'épaisseur de la deuxième couche sacrificielle **42** déposée au dessus de la micro-planche **14** tient compte de l'épaisseur de la couche **50,** la somme des épaisseurs de la couche **42** et de la couche 50 étant égale à la distance *l* souhaitée entre la membrane focalisatrice **22** et la micro-planche **14.**

Le matériau de la couche **50** est avantageusement choisi pour être compatible avec le matériau du substrat **16,** notamment en termes d'adhérence et de conformité de dépôt.

Le matériau de la couche **50** est par ailleurs choisi pour être peu absorbant dans la gamme de longueurs d'onde à détecter. Par exemple, pour la gamme de longueurs d'onde infrarouge, le matériau de la couche **50** est du germanium, du silicium ou du Si-Ge, et pour la gamme de longueurs d'onde térahertz, le matériau de la couche **50** est un oxyde de silicium SiOx, du SiON ou du SiN.

L'épaisseur de la couche **50,** sur laquelle sera ultérieurement formée la membrane **22,** est avantageusement sélectionnée de manière à ce que la couche **50** soit optiquement neutre.

A cet effet, l'épaisseur vérifie sensiblement la relation $h_2 = \dfrac{m \times \lambda}{2 \times n_2}$, où $h_2$ est ladite épaisseur, $n_2$ est l'indice de réfraction de la couche de support, et $m$ est un entier positif supérieur ou égal à 1.

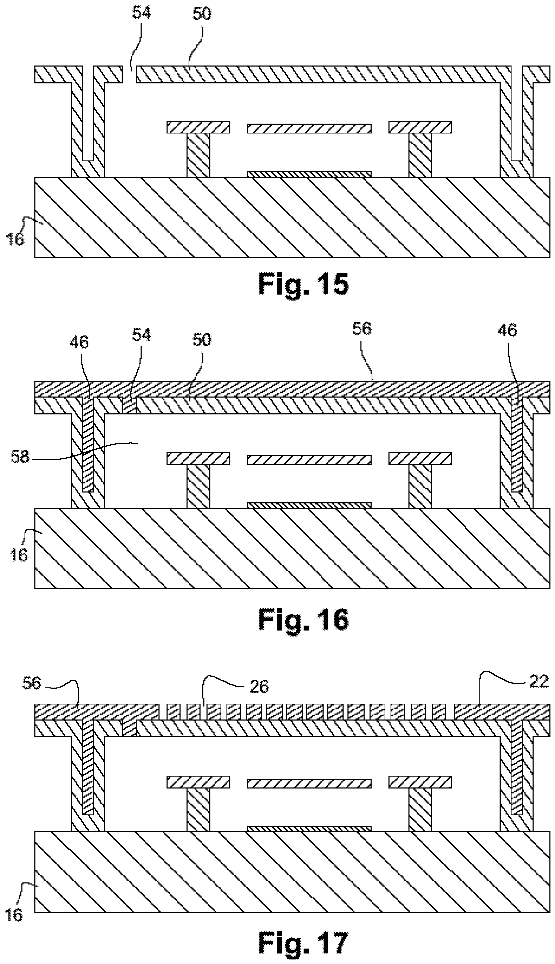

Ce procédé se poursuit par une lithographie et une gravure, par exemple une gravure sèche du type RIE, pour réaliser un évent de libération **54** dans la couche **50** jusqu'à la couche sacrificielle **44** (figure 14). La couche sacrificielle **44** est alors retirée, par exemple au moyen d'un plasma d'oxygène ou d'ozone appliqué au travers de l'évent de libération **54** (figure 15).

Le procédé se poursuit par le dépôt pleine plaque du matériau constitutif de la membrane focalisatrice, par exemple l'un de ceux décrit précédemment, de manière à former une couche **56** recouvrant la couche **50,** y compris dans les tranchées **46** et l'évent de libération **54** (figure 16). Un espace hermétique **58** est ainsi obtenu autour de la micro-planche **14** et des éléments de soutien **18.** Le dépôt de la couche **56** est réalisé par pulvérisation, dépôt CVD ou évaporation afin d'obtenir un vide poussé dans l'espace **60.** Il est ainsi obtenu un packaging hermétique intégré pour la micro-planche **14.**

Si l'on veut maximiser l'isolation thermique du détecteur afin d'augmenter sa sensibilité, on utilisera toutefois préférentiellement pour le dépôt de la couche **56** des procédés de dépôt se déroulant à très basse pression, typiquement des pressions inférieure ou égales à 1 mTorr afin de minimiser la pression dans la cavité au moment du scellement de celle-ci par le dépôt de la couche **56.**

De plus, si l'on souhaite également maximiser la durée de vie du vide et donc celle du détecteur, il est souhaitable de réduire au maximum le nombre d'espèces susceptibles de dégazer à l'intérieur de la cavité au cours de la durée de vie du détecteur. Les gaz précurseurs des dépôts de type CVD font typiquement partie de ces espèces, de même les ions utilisés (typiquement de l'argon) pour pulvériser le matériau de la couche **56** dans le cas d'un dépôt par pulvérisation sont susceptibles de dégazer par la suite dans la cavité. Une solution pour limiter le dégazage est donc l'utilisation d'un procédé d'évaporation pour réaliser le dépôt de la couche **56.**

Cependant, les dépôts par évaporation sont habituellement très peu conformes avec un axe de croissance de la couche déposée essentiellement orienté verticalement. Il peut donc s'avérer difficile voire impossible (selon la taille de l'évent **54**) de sceller hermétiquement l'évent **54** avec un dépôt par évaporation. Ceci est dû au fait que les atomes évaporés sont très faiblement énergétiques et parcourent donc une très faible distance une fois rentré en contact avec la surface servant de support au dépôt (ici la couche 50).

Une solution pour profiter tout de même du très bon niveau de vide et de la faible capacité de dégazage offert par les dépôts par évaporation est d'augmenter l'énergie des atomes évaporés une fois que ceux-ci rentrent en contact avec le support du dépôt (ici la couche 50). Ceci peut être réalisé par exemple en chauffant le substrat 16 pendant l'évaporation, typiquement au-dessus de 150°C. La couche 50 étant en contact direct avec le substrat **16** grâce aux tranchées **46,** elle sera donc chauffée également et cédera de l'énergie aux atomes évaporés incidents augmentant ainsi la distance parcouru par ceux-ci à la surface de la couche **50** ce qui rendra possible ou facilitera (selon la taille de l'évent **54**) le scellement de l'évent **54** en augmentant la conformité du dépôt de la couche **56.**

Une lithographie et une gravure, par exemple une gravure sèche du type RIE, sont ensuite mises en œuvre pour réaliser les ouvertures **26** dans la couche **56,** afin de former la membrane focalisatrice **22** de l'invention. La gravure est réalisée dans la totalité de l'épaisseur de la couche **56** (figure 17), ou partiellement dans l'épaisseur de celle-ci (figure 18), auquel cas l'épaisseur $h_1$ des motifs décrite précédemment est l'épaisseur gravée de la couche **56,** ou dans la totalité de la couche **56** et partiellement dans l'épaisseur de la couche **50** (figure 19).

La réalisation de la gravure du réseau dans la totalité de l'épaisseur de la couche **56** (figure 17) permet l'utilisation d'une couche d'arrêt lors de l'étape de gravure. La présence d'une couche d'arrêt offre plusieurs avantages pour la réalisation de la membrane focalisatrice **22**. Elle permet de s'affranchir des éventuelles inhomogénéités du procédé de gravure en ayant recours à la surgravure. De même, la surgravure permettra d'assurer que la gravure de la couche **56** est bien complète dans les ouvertures 26 même en cas de dérive de l'équipement utilisé pour réaliser la gravure. L'utilisation d'une couche d'arrêt permet donc d'augmenter la maitrise du procédé de gravure des ouvertures 26 et donc le rendement de production de la membrane focalisatrice **22**. De plus, la présence d'une couche d'arrêt permet de garantir que la profondeur des ouvertures **26** est identique sur l'ensemble des détecteurs de la matrice et assure ainsi l'homogénéité de la focalisation et donc de l'absorption à l'échelle de la matrice ce qui est primordial pour la réalisation d'images.

Cependant, l'utilisation de la couche **50** comme couche d'arrêt nécessite d'employer un procédé de gravure de la couche **56** présentant une très forte sélectivité vis-à-vis du matériau constitutif de la couche **50** (typiquement du silicium). Or très souvent cette sélectivité est difficile ou impossible à obtenir. Par exemple, pour des raisons de facilité d'intégration le matériau de la couche **56** peut être identique à celui de la couche **50** (typiquement du silicium), ou bien les matériaux des couches **56** et **50** (typiquement le germanium et le silicium) peuvent présenter les mêmes sensibilités aux chimies utilisées pour la gravure.

Afin de pouvoir utiliser tout de même une couche d'arrêt pour la gravure de la couche **56** (pour bénéficier des avantages cités précédemment), une solution est d'intégrer avant le dépôt de la couche **56** une étape d'oxydation de surface de la couche **50**. Par exemple, une phase de montée en température au-dessus de 100°C à la fin de l'étape de libération permettra d'oxyder la couche **50**. L'oxyde de surface ainsi créé est alors suffisant pour servir de couche d'arrêt tout en restant suffisamment mince, typiquement entre 10 et 20nm, pour ne pas perturber la transmission de l'onde incidente. Typiquement, un procédé de gravure RIE avec un débit de de bromure d'hydrogène (HBr) permettra de graver le silicium ou le germanium constitutif de la couche **56** tout en s'arrêtant sur l'oxyde de surface du silicium de la couche **50.**

Une variante du mode de réalisation de la structure de soutien et son procédé de fabrication sont décrits à présent en relation avec les figures schématiques en coupe 20 à 22, cette variante permettant d'accélérer l'élimination des couches sacrificielles **44** et/ou d'utiliser un procédé de libération moins contraignant pour le détecteur, comme par exemple un procédé à plus basse température et/ou à plus faible puissance.

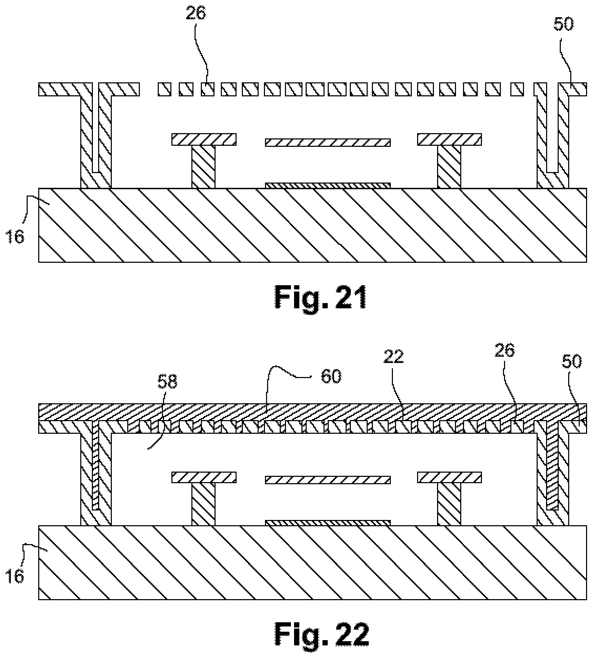

Le procédé débute par les étapes décrites précédemment pour obtenir la structure décrite en relation avec la figure 13, et se poursuit par une lithographie et une gravure, par exemple une gravure sèche du type RIE, dans la totalité de la couche **50** afin de définir des motifs **26** de bas indice de réfraction qui seront ultérieurement en alternance avec le matériau de haut indice de réfraction de la membrane (figure 20). La couche sacrificielle **44** est alors retirée, par exemple au moyen d'un plasma d'oxygène ou d'ozone appliqué au travers des ouvertures pratiquées dans la couche **50** (figure 21).

Le procédé se poursuit par le dépôt pleine plaque du matériau constitutif de la membrane focalisatrice, par exemple l'un de ceux décrits précédemment, de manière à former une couche **60** recouvrant la couche **50** et remplissant les ouvertures entre les motifs **26,** y compris dans les tranchées **46** (figure 22). Le dépôt de la couche **60** est réalisé par pulvérisation, dépôt CVD ou évaporation afin d'obtenir un vide poussé dans l'espace **58.** Il est ainsi obtenu un packaging hermétique intégré pour la micro-planche **14.**

Il a été décrit des applications de la présente invention à des micro-planches bolométriques qui sont suspendues par des éléments de soutien individuels, c'est-à-dire ne suspendant qu'une micro-planche à la fois. Une vue de dessus d'un exemple d'une matrice de micro-planches **14** avec des éléments de soutien **18** individuels est représentée à la figure 23.

Il existe cependant des architectures dans lesquelles un élément de soutien suspend conjointement deux micro-planches adjacentes, comme illustré à la figure 24, qui est une vue de dessus d'une matrice de micro-planches avec des éléments de soutien **18** communs.

En revanche, avec des éléments de soutien communs, il n'est pas possible de réaliser une structure de soutien pour une membrane focalisatrice formée d'une paroi latérale continue autour de la micro-planche et de ses éléments de soutien, à la différence de l'architecture à éléments de soutien individuels dans laquelle il existe un espace libre tout autour de chaque micro-planche et de ses éléments de soutien. On comprend donc aisément que la fabrication de cette structure dans une architecture à base d'éléments de soutien commun est complexe dès lors que l'on souhaite faire reposer celle-ci sur le substrat.

Il va à présent être décrit, en relation avec les figures schématiques en coupe 25 à 30, un procédé de fabrication simple d'une membrane focalisatrice dans une architecture à base d'éléments de soutien communs.

Le procédé débute par la fabrication, sur le substrat **16,** de la matrice de micro-planches **14,** des éléments de soutien communs **18** et des réflecteurs **20.** Cette étape de fabrication est classique, et comme cela est connu en soi, les micro-planches **14** sont réalisées sur une couche sacrificielle **40** déposée sur le substrat **16** (figure 25).

Une fois les micro-planches **14** formées, le procédé se poursuit en déposant une deuxième couche sacrificielle **42** sur la première couche sacrificielle **40,** les micro-planches **14** et les éléments de soutien communs **18.** L'épaisseur de la deuxième couche **42** est égale à la distance *l* désirée entre la membrane focalisatrice **22** et la micro-planche **14** (figure 26). La deuxième couche **42** est par exemple déposée au moyen d'une technique de dépôt à la tournette (« *spin coating* »), et est constituée avantageusement du même matériau que la première couche **40,** notamment un polyimide, un polymère par exemple à base de BCB (benzocyclobutène), une résine photosensible recuite ou autres. Les première et deuxième couches **40, 42** forment ensemble une couche sacrificielle globale **44.**

Une étape de gravure de la couche sacrificielle **44** est alors mise en œuvre pour former des tranchées **62** débouchant sur au moins une portion des éléments de soutien communs **18,** et plus exactement une portion, ou la totalité, de la structure verticale des éléments **18** liée mécaniquement au substrat **16** (figure 27). Par exemple une gravure sèche du type RIE, qui permet une anisotropie élevée de la gravure, est mise en œuvre.

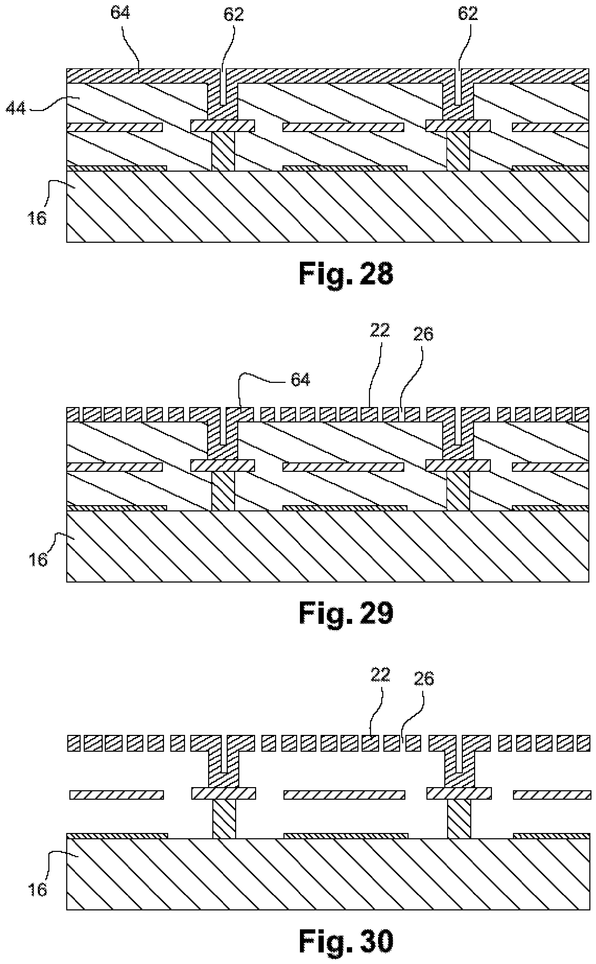

Un matériau transparent au rayonnement à détecter, par exemple l'un de ceux décrits précédemment, est alors déposé pleine plaque de sorte que la couche sacrificielle **44** et les tranchées **62** sont recouvertes d'une couche **64** de ce matériau (figure 28).

Une lithographie et une gravure, par exemple une gravure sèche du type RIE, sont ensuite mises en œuvre pour réaliser les motifs **26** dans la couche **64** afin de former la membrane focalisatrice **22** de l'invention (figure 29). Enfin, la couche sacrificielle **44** est retirée, par exemple au moyen d'un plasma d'oxygène ou d'ozone (figure 30).

Bien que seule la membrane focalisatrice soit réalisée selon le mode de réalisation décrit, il est prévu selon l'invention de fournir une couche diélectrique et/ou semi-conductrice de manière analogue aux modes de réalisation décrits en relation avec les modes de réalisation des figures 13 à 19. De manière avantageuse, la couche supplémentaire sera constituée d'un matériau en outre isolant thermiquement afin de perturber au minimum la fonction d'isolation thermique des éléments de soutien communs. De même, il est possible de fabriquer la membrane focalisatrice de manière analogue au procédé décrit en relation avec les figures 20 à 22.

De même, si l'application le nécessite, il est possible également de prévoir des structures de soutien de membrane focalisatrice qui prennent appui sur des éléments de soutien individuels.

L'invention peut avantageusement être utilisée dans le cadre d'un micro-packaging hermétique intégré : une membrane focalisatrice, placée dans le plan supérieur du micro-packaging, permet ainsi de compenser la perte de surface optiquement active induite par les flancs du micro-packaging. On bénéficie ainsi de la baisse de coût de production permise par la réalisation collective du packaging tout en minimisant la baisse de rendement du détecteur nécessairement induite par ce type de packaging.

L'invention peut également être utilisée pour accroître la taille des pixels sans accroître la surface des micro-planches, l'accroissement de surface des pixels pouvant être utilisée pour améliorer des fonctions existantes ou en rajouter de nouvelle. Par exemple, la surface dédiée aux éléments d'isolation thermique des micro-planches bolométriques peut être augmentée, comme cela est illustré à la figure 31 qui est une vue de dessus schématique d'une micro-planche **14** avec des éléments d'isolation thermique rallongés **70** disposés sous une membrane **22** selon l'invention, dont l'emprise est illustrée par le carré en trait pointillé.

Dans un autre exemple, l'accroissement de la surface du pixel peut être utilisé pour prévoir un deuxième élément de détection, comme cela est illustré à la vue schématique de dessus de la figure 32 dans laquelle une antenne térahertz **72** est spécifiquement prévue à la détection du rayonnement térahertz.

Dans un autre exemple, illustré à la figure 33, l'accroissement de surface par pixel est utilisé pour mettre en œuvre des fonctions supplémentaires, par exemple une conversion numérique du signal du pixel, ou un capteur visible au niveau CMOS, dans le substrat au dessus duquel sont suspendues les micro-planches bolométriques.

## Revendications

1. Détecteur bolométrique matriciel pour la détection d'un rayonnement électromagnétique dans une gamme prédéterminée de longueurs d'onde infrarouges ou térahertz, comprenant :

   - un substrat (16); et
   - une matrice de micro-planches bolométriques (14) pour la détection dudit rayonnement, suspendues au-dessus du substrat à l'aide d'éléments de soutien (18), *caractérisé :*
   - en ce qu'il comporte :

     ○ une couche de support (50) au moins partiellement transparente au rayonnement à détecter, et dont l'épaisseur vérifie sensiblement la relation $h_2 = \dfrac{m \times \lambda}{2 \times n_2}$, où $h_2$ est ladite épaisseur, $n_2$ est l'indice de réfraction de la couche de support, et $m$ est un entier positif supérieur ou égal à 1 ; ladite couche de support (50) présentant des parois latérales de soutien

     ○ une membrane (22), sensiblement transparente au rayonnement à détecter, reposant sur la couche de support (50) et s'étendant dans un évent de libération (54) de ladite couche de support (50) de sorte que ladite couche de support (50) forme avec ses parois latérales de soutien et la membrane (22) une enceinte hermétique (58) dans laquelle est positionné un ensemble d'au moins une micro-planche comportant ladite micro-planche (14), ladite membrane (22) ayant un premier indice de réfraction, disposée au-dessus de chaque micro-planche (14), et dans laquelle sont formés des motifs (26) de second indice de réfraction, inférieur au premier indice de réfraction, sur au moins une partie de l'épaisseur de la membrane (22) ; et

   - et en ce que :

     ○ les motifs (26) de la membrane (22) sont placés périodiquement dans celle-ci, le long d'au moins un axe prédéterminé, selon une période inférieure ou égale à $\dfrac{\lambda}{n}$, où $\lambda$ est une longueur d'onde de la gamme de longueurs d'onde à détecter et $n$ est l'indice de réfraction du milieu séparant la micro-planche (14) de la membrane (22) ;
     ○ la largeur des motifs (26) selon le ou chaque axe prédéterminé augmente depuis un emplacement de la membrane (22), positionné au-dessus d'une zone centrale de la micro-planche (14), en direction de la périphérie de la membrane (22).

2. Détecteur bolométrique matriciel selon la revendication 1, *caractérisé en ce que* ladite période est sensiblement égale à $\dfrac{\lambda}{4 \times n}$.

3. Détecteur bolométrique matriciel selon la revendication 1 ou 2, *caractérisé en ce que* la largeur des motifs (26) audit emplacement de la membrane (22) vérifie la relation $\dfrac{W_0}{P} \le 0{,}5$, où $W_0$ est la largeur des motifs (26) audit emplacement et $P$ est la période selon l'axe prédéterminé.

4. Détecteur bolométrique matriciel selon la revendication 1, 2 ou 3, *caractérisé en ce que* l'écart ($W_{n+1} - W_n$) de largeurs $W_n$ et $W_{n+1}$ entre deux motifs (26) adjacents est inférieur ou égal à $\dfrac{\lambda}{10 \times n}$.

5. Détecteur bolométrique matriciel selon l'une quelconque des revendications précédentes, *caractérisé en ce que* l'épaisseur des motifs (26) est supérieure ou égale à $\dfrac{\lambda}{10 \times n}$.

6. Détecteur bolométrique matriciel selon l'une quelconque des revendications précédentes, *caractérisé en ce que* $m$ est égal à 1.

**7.** Détecteur bolométrique matriciel selon la revendication 6, *caractérisé* **en ce que** les motifs (26) de la membrane (22) sont également réalisés dans la couche de support (50) au moins sur une partie de l'épaisseur de celle-ci.

**8.** Détecteur bolométrique matriciel selon l'une quelconque des revendications précédentes, *caractérisé* **en ce que** l'enceinte hermétique est une enceinte individuelle ne comportant qu'une micro-planche.

**9.** Détecteur bolométrique matriciel selon l'une quelconque des revendications précédentes, *caractérisé* **en ce que les motifs (26) sont constitués par des ouvertures pratiquées dans la** membrane et remplies d'un gaz, notamment de l'air.

**10.** Détecteur bolométrique matriciel selon l'une quelconque des revendications précédentes, *caractérisé* **en ce que** la membrane (22) est soutenue par une structure prenant appui sur au moins une partie des éléments de soutien (18) de la micro-planche (14).

**11.** Détecteur bolométrique matriciel selon l'une quelconque des revendications précédentes, *caractérisé* **en ce que** les motifs (26) de la membrane (22) sont des bandes parallèles.

**12.** Détecteur bolométrique matriciel selon l'une quelconque des revendications précédentes, *caractérisé* **en ce que** les motifs de la membrane sont carrés ou circulaires.

**13.** Détecteur bolométrique matriciel selon l'une quelconque des revendications précédentes, *caractérisé* **en ce que** la membrane (22) est constituée de germanium, de silicium ou d'un alliage de ceux-ci.

**14.** Détecteur bolométrique matriciel selon l'une quelconque des revendications précédentes, *caractérisé* **en ce que** la membrane (22) est constituée de SiOx, de SiON, de SiN, ou d'un alliage de ceux-ci.

**15.** Procédé de fabrication d'un détecteur bolométrique conforme à l'une quelconque des revendications précédentes, comprenant la réalisation d'une matrice de micro-planches bolométriques (14) suspendues au-dessus d'un substrat (16) à l'aide d'éléments de soutien (18), la réalisation de la matrice de micro-planches comportant le dépôt d'une première couche sacrificielle (40) sur le substrat (16) et le dépôt des micro-planches (14) sur la première couche sacrificielle (40), *caractérisé* **en ce qu'**il comporte :

- le dépôt, sur la première couche sacrificielles (40) et les membranes bolométriques (14), d'une seconde couche sacrificielle (42) ;

- le dépôt, sur la deuxième couche sacrificielle (42), d'une couche de support (50) au moins partiellement transparente au rayonnement à détecter, et dont l'épaisseur vérifie sensiblement la relation $h_2 = \dfrac{m \times \lambda}{2 \times n_2}$, où $h_2$ est ladite épaisseur, $n_2$ est l'indice de réfraction de la couche de support, et $m$ est un entier positif supérieur ou égal à 1 ;

- le dépôt, sur la couche de support (50) et au-dessus de chaque micro-planche (14), d'une couche (56) sensiblement transparente au rayonnement à détecter ayant un premier indice de réfraction ;

- la réalisation sur au moins une partie de l'épaisseur de chaque couche de premier indice de réfraction (56) disposée au-dessus d'une micro-planche (14), de motifs (26) de second indice de réfraction inférieur au premier indice de réfraction, les motifs (26) étant placés périodiquement dans celle-ci, le long d'au moins un axe prédéterminé, selon une période inférieure ou égale à $\dfrac{\lambda}{n}$, où $\lambda$ est une longueur d'onde de la gamme de longueurs d'onde à détecter et $n$ est l'indice de réfraction d'un milieu séparant la micro-planche (14) de la couche de premier indice de réfraction (56) une fois les première et seconde couches sacrificielles retirées, et la largeur des motifs (26) selon le ou chaque axe prédéterminé augmentant depuis un emplacement de la couche (56), positionné au-dessus d'une zone centrale de la micro-planche (14), en direction de la périphérie de la couche (56) ; et

- le retrait des première et seconde couches sacrificielles (40, 42).

**16.** Procédé selon la revendication 15, *caractérisé* **en ce que** la réalisation des motifs (26) comporte la gravure de la couche de premier indice de réfraction (56) dans la totalité de l'épaisseur de celle-ci, et **en ce que** la couche de support (50) et la gravure sont choisies de manière à obtenir une gravure sélective de la couche de premier indice de réfraction (56).

**17.** Procédé selon la revendication 16, *caractérisé* **en ce que** le dépôt de la couche de support (50) comporte le dépôt d'une première couche de matériau oxydable et une étape d'oxydation de la surface libre de la couche de support de manière à obtenir une couche d'oxyde.

**Patentansprüche**

1. Bolometrischer Matrixdetektor zur Erkennung einer elektromagnetischen Strahlung in einem vorher festgelegten Infrarot- oder Terahertz-Wellenlängenbereich, der umfasst:

   ▪ ein Substrat (16); und
   ▪ eine Matrix bolometrischer Mikroplatten (14) zur Erkennung der erwähnten Strahlung, aufgehängt oberhalb des Substrats mit Hilfe von Trägerelementen (18),
   ***dadurch gekennzeichnet,***
   ▪ **dass** er enthält:

      ∘ eine Trägerschicht (50), die zumindest teilweise gegenüber der zu erkennenden Strahlung transparent ist und deren Dicke im Wesentlichen der Formel $h_2 = \dfrac{m \times \lambda}{2 \times n_2}$, entspricht, worin $h_2$ diese Dicke ist, $n_2$ der Refraktionsindex der Trägerschicht ist und $m$ ist eine positive ganze Zahl größer oder gleich 1; die erwähnte Trägerschicht (50) weist dabei seitliche Stützwände auf;
      ∘ eine Membran (22), die im Wesentlichen transparent gegenüber der zu erkennenden Strahlung ist, die auf der Trägerschicht (50) aufliegt und die in einer Freigabeöffnung (54) dieser Trägerschicht (50) verläuft, so dass diese Trägerschicht (50) zusammen mit ihren seitlichen Stützwänden und der Membran (22) ein hermetisches Gehäuse (58) bildet, in dem eine Einheit aus mindestens einer Mikroplatte untergebracht ist, die diese Mikroplatte (14) enthält, diese Membran (22), die einen ersten Refraktionsindex aufweist, ist über jeder Mikroplatte (14) angeordnet und in ihr sind auf mindestens einem Teil der Dicke der Membran (22) Muster (26) mit einem zweiten Refraktionsindex, kleiner als der erste Refraktionsindex, gebildet; und

   ▪ dadurch, dass:

      ∘ die Muster (26) der Membran (22) darin regelmäßig, entlang einer vorher festgelegten Achse verteilt sind, innerhalb eines Zeitintervalls kleiner oder gleich $\dfrac{\lambda}{n}$, worin $\lambda$ eine Wellenlänge aus dem Bereich der zu erkennenden Wellenlängen ist und n der Refraktionsindex des Mediums, das die Mikroplatte (14) von der Membran (22) trennt;

      ∘ die Breite der Muster (26) entlang der oder jeder vorher festgelegten Achse ansteigt, ab einer Position der Membran (22), die sich über einer zentralen Zone der Mikroplatte (14) befindet, in Richtung auf die Peripherie der Membran (22).

2. Bolometrischer Matrixdetektor nach Anspruch 1, ***dadurch gekennzeichnet, dass*** das erwähnte Zeitintervall im Wesentlichen gleich $\dfrac{\lambda}{4 \times n}$. ist.

3. Bolometrischer Matrixdetektor nach Anspruch 1 oder 2, ***dadurch gekennzeichnet, dass*** die Breite der Muster (26) an dieser Position der Membran (22) der Gleichung $\dfrac{W_0}{P} \leq 0,5$, entspricht, worin $W_o$ die Breite der Muster (26) an dieser Position ist und P das Zeitintervall entlang der vorher festgelegten Achse.

4. Bolometrischer Matrixdetektor nach Anspruch 1, 2 oder 3, ***dadurch gekennzeichnet, dass*** der Abstand *($W_{n+l}$ - $W_n$)* zwischen zwei Breiten $W_{n+l}$ und $W_n$ zwischen zwei nebeneinanderliegenden Mustern (26) kleiner oder gleich $\dfrac{\lambda}{10 \times n}$. ist.

5. Bolometrischer Matrixdetektor nach einem beliebigen der vorangehenden Ansprüche, ***dadurch gekennzeichnet, dass,*** die Dicke der Muster (26) höher oder gleich $\dfrac{\lambda}{10 \times n}$. ist.

6. Bolometrischer Matrixdetektor nach einem beliebigen der vorangehenden Ansprüche, ***dadurch gekennzeichnet, dass*** m gleich 1 ist.

7. Bolometrischer Matrixdetektor nach Anspruch 6, ***dadurch gekennzeichnet, dass*** die Muster (26) der Membran (22) auch in der Trägerschicht (50) ausgeführt sind, zumindest auf einem Teil ihrer Dicke.

8. Bolometrischer Matrixdetektor nach einem beliebigen der vorangehenden Ansprüche, ***dadurch gekennzeichnet, dass*** das hermetische Gehäuse ein Einzelgehäuse ist, das nur eine Mikroplatte enthält.

9. Bolometrischer Matrixdetektor nach einem beliebigen der vorangehenden Ansprüche, ***dadurch gekennzeichnet, dass*** die Muster (26) aus Öffnungen gebildet werden, die in der Membran vorgesehen sind und mit Gas, insbesondere Luft, gefüllt sind.

**10.** Bolometrischer Matrixdetektor nach einem beliebigen der vorangehenden Ansprüche, *dadurch gekennzeichnet, dass* die Membran (22) von einer Struktur gestützt wird, die auf mindestens einem Teil der Haltelemente (18) der Mikroplatte (14) aufsteht.

**11.** Bolometrischer Matrixdetektor nach einem beliebigen der vorangehenden Ansprüche, *dadurch gekennzeichnet, dass* die Muster (26) der Membran (22) parallele Streifen sind.

**12.** Bolometrischer Matrixdetektor nach einem beliebigen der vorangehenden Ansprüche, *dadurch gekennzeichnet, dass* die Muster der Membran quadratisch oder ringförmig sind.

**13.** Bolometrischer Matrixdetektor nach einem beliebigen der vorangehenden Ansprüche, *dadurch gekennzeichnet, dass* die Membran (22) aus Germanium, Silizium oder einer Legierung daraus besteht.

**14.** Bolometrischer Matrixdetektor nach einem beliebigen der vorangehenden Ansprüche, *dadurch gekennzeichnet, dass* die Membran (22) aus SiOx, SiON, SiN oder einer Legierung daraus besteht.

**15.** Verfahren zur Herstellung eines bolometrischen Detektors nach einem beliebigen der vorangehenden Ansprüche, umfassend die Herstellung einer bolometrischen Mikroplattenmatrix (14) aufgehängt über einem Substrat (16) mit Hilfe von Haltelementen (18), die Herstellung der Mikroplattenmatrix enthält dabei die Abscheidung einer ersten Opferschicht (40) auf dem Substrat (16) und die Abscheidung der Mikroplatten (14) auf der ersten Opferschicht (40), *dadurch gekennzeichnet, dass* es enthält:

- die Abscheidung einer zweiten Opferschicht (42) auf der ersten Opferschicht (40) und den bolometrischen Membrane (14);
- die Abscheidung auf der zweiten Opferschicht (42) einer Trägerschicht (50) die zumindest teilweise gegenüber der zu erkennenden Strahlung transparent ist und deren Dicke im Wesentlichen der Formel $h_2 = \dfrac{m \times \lambda}{2 \times n_2}$, entspricht, worin $h_2$ diese Dicke ist, $n_2$ der Refraktionsindex der Trägerschicht ist und $m$ eine positive ganze Zahl größer oder gleich 1;
- die Abscheidung auf der Trägerschicht (50) und über jeder Mikroplatte (14), einer Schicht (56), die im Wesentlichen gegenüber der zu erkennenden Strahlung transparent ist und einen ersten Refraktionsindex aufweist;
- die Ausführung auf mindestens einem Teil der Dicke jeder Schicht mit dem ersten Refraktionsindex (56), die über einer Mikroplatte (14) angeordnet ist, von Mustern (26) mit dem zweiten Refraktionsindex, der kleiner ist als der erste Refraktionsindex, die Muster (26) sind dabei regelmäßig darin angeordnet, entlang mindestens einer vorher bestimmten Achse, entsprechend einem Intervall kleiner oder gleich $\dfrac{\lambda}{n}$, worin $\lambda$ eine Wellenlänge aus dem Bereich der zu erkennenden Wellenlängen ist und $n$ der Refraktionsindex des Mediums, das die Mikroplatte (14) von der Membran (22) trennt, sobald die erste und zweite Opferschichten entfernt wurden und die Breite der Muster (26) entlang der oder jeder vorher festgelegten Achse erhöht sich von einer Position der Schicht (56) aus, die oberhalb einer zentralen Zone der Mikroplatte (14) angeordnet ist, in Richtung hin zur Peripherie der Schicht (56) ; und

- die Entfernung der ersten und zweiten Opferschicht (40, 42).

**16.** Verfahren nach Anspruch 1, *dadurch gekennzeichnet, dass* die Ausführung der Muster (26) ein Ätzen der Schicht mit dem ersten Refraktionsindex (56) in ihrer gesamten Dicke enthält, und dadurch, dass die Trägerschicht (50) und das Ätzen so gewählt werden, dass ein selektives Ätzen der Schicht mit dem ersten Refraktionsindex (56) erreicht wird.

**17.** Verfahren nach Anspruch 16, *dadurch gekennzeichnet, dass* das Abscheiden der Trägerschicht (50) das Abscheiden einer ersten Schicht oxidierbaren Materials umfasst sowie einen Schritt des Oxidierens der freien Fläche der Trägerschicht so dass sich eine Oxidschicht ergibt.

**Claims**

**1.** An array bolometric detector for the detection of an electromagnetic radiation in a predetermined range of infrared or terahertz wavelengths, comprising:

- a substrate (16); and
- an array of bolometric microplates (14) for the detection of said radiation, suspended above the substrate by means of support elements (18), **characterized in that**:
- it comprises:

  ◦ a support layer (50) at least partially transparent to the radiation to be detected and having its thickness substantially complying with relation $h_2 = \dfrac{m \times \lambda}{2 \times n_2}$, where $h_2$ is said thickness, $n_2$ is the refractive index of the support layer, and $m$ is a positive integer greater than or equal to 1, said support layer (50) having lateral support walls;

○ a membrane (22) substantially transparent to the radiation to be detected and resting on the support layer (50) such that said support layer (50) forms with its lateral support walls and the membrane (22) a tight enclosure (58) having an assembly of at least one microplate comprising said microplate (14) arranged therein, said membrane (22) having a first refractive index, arranged above each microplate (14), and wherein patterns (26) are formed, which have a second refractive index smaller than the first refractive index, across at least a portion of the thickness of the membrane (22);

■ and **in that**:

○ the patterns (26) of the membrane (22) are placed periodically therein, along at least one predetermined axis, according to a period shorter than or equal to $\dfrac{\lambda}{n}$, where $\lambda$ is a wavelength from the wavelength range to be detected

$n$

and $n$ is the average refractive index of the medium separating the microplate (14) from the membrane (22);

○ the width of the patterns (26) along the or each predetermined axis increases from a location of the membrane (22), positioned above a central area of the microplate (14), towards the periphery of the membrane (22).

2. The array bolometric detector of claim 1, **characterized in that** said period is substantially equal to $\dfrac{\lambda}{4 \times n}$.

3. The array bolometric detector of claim 1 or 2, **characterized in that** the width of the patterns (26) at said location of the membrane (22) complies with relation $\dfrac{W_0}{P} \leq 0.5$, where $W_0$ is the width of the patterns (26) at said location and P is the period along the predetermined axis.

4. The array bolometric detector of claim 1, 2, or 3, **characterized in that** difference ($\underline{W_{n+1}}$ - $\underline{W_n}$) of widths $\underline{W_n}$ and $\underline{W_{n+1}}$ between two adjacent patterns (26) is smaller than or equal to $\dfrac{\lambda}{10 \times n}$.

5. The array bolometric detector of any of the foregoing claims, **characterized in that** the thickness of the patterns (26) is greater than or equal to $\dfrac{\lambda}{10 \times n}$.

6. The array bolometric detector of any of the foregoing claims, **characterized in that** $m$ is equal to 1.

7. The array bolometric detector of claim 6, **characterized in that** the patterns (26) of the membrane (22) are also formed in the support layer (50) at least across a portion of the thickness thereof.

8. The array bolometric detector of any of the foregoing claims, **characterized in that** the tight enclosure is an individual enclosure comprising a single microplate.

9. The array bolometric detector of any of the foregoing claims, **characterized in that** the patterns (26) are formed by openings made in the membrane and filled with a gas, particularly air.

10. The array bolometric of any of the foregoing claims, **characterized in that** the membrane (22) is supported by a structure bearing on at least a portion of the support elements (18) of the microplate (14).

11. The array bolometric detector of any of the foregoing claims, **characterized in that** the patterns (26) of the membrane (22) are parallel strips.

12. The array bolometric detector of any of the foregoing claims, **characterized in that** the patterns of the membrane are square or circular.

13. The array bolometric detector of any of the foregoing claims, **characterized in that** the membrane (22) is made of germanium, of silicon, or of an alloy thereof.

14. The array bolometric detector of any of the foregoing claims, **characterized in that** the membrane (22) is made of SiOx, of SiON, of SiN, or of an alloy thereof.

15. A method of manufacturing the bolometric detector of any of the foregoing claims, comprising forming an array of bolometric microplates (14) suspended above a substrate (16) by means of support elements (18), the forming of the microplate array comprising depositing a first sacrificial layer (40) on the substrate (16) and depositing the microplates (14) on the first sacrificial layer (40), **characterized in that** it comprises:

- depositing, on the first sacrificial layer (40) and the bolometric membranes (14), a second sacrificial layer (42);
- depositing, on the second sacrificial layer (42), a support layer (50) at least partially transparent to the radiation to be detected and having its thickness substantially complying with relation $h_2 = \dfrac{m \times \lambda}{2 \times n_2}$, where $h_2$ is said thickness, $n_2$ is the refractive index of the support layer, and $m$ is a positive integer greater than or equal to 1;
- depositing, on the support layer (50) and above each microplate (14), a layer (56) substantially transparent to the radiation to be detected having a first refractive index;
- forming across at least a portion of the thickness of each layer (56) arranged above a microplate (14), patterns (26) having a second refractive index smaller than the first refractive index, the patterns (26) being periodically placed therein, along at least one predetermined axis, according to a period smaller than or equal to $\dfrac{\lambda}{n}$, where $\lambda$ is a wavelength from the wavelength range to be detected and $n$ is the average refractive index of a medium separating the microplate (14) from the layer (56) once the first and second sacrificial layers have been removed, and the width of the pattern (26) along the or each predetermined axis increasing from a location of the layer (56), positioned above a central area of the microplate (14), towards the periphery of the layer (56); and
- removing the first and second sacrificial layers (40, 42).

16. The method of claim 15, **characterized in that** the forming of the patterns (26) comprises etching the layer (56) across its entire thickness, and **in that** the support layer (50) and the etching are selected to obtain a selective etching of the layer (56).

17. The method of claim 16, **characterized in that** the deposition of the support layer (50) comprises depositing a first layer of an oxidizable material and a step of oxidizing the free surface of the support layer to obtain an oxide layer.

Fig. 1

Fig. 2

Fig. 3

Fig. 4

Fig. 5A

**Fig. 5B**

**Fig. 6**

Fig. 7

Fig. 8

Fig. 9

**Fig. 10**

**Fig. 11**

**Fig. 12**

EP 2 786 105 B1

**Fig. 13**

**Fig. 14**

**Fig. 15**

**Fig. 16**

**Fig. 17**

**Fig. 18**

**Fig. 19**

**Fig. 20**

**Fig. 21**

**Fig. 22**

Fig. 23

Fig. 24

**Fig. 25**

**Fig. 26**

**Fig. 27**

64    62                    62

44

16

**Fig. 28**

64    22    26

16

**Fig. 29**

22    26

16

**Fig. 30**

**Fig. 31**

**Fig. 32**

**Fig. 33**

**RÉFÉRENCES CITÉES DANS LA DESCRIPTION**

**Documents brevets cités dans la description**

- US 6094127 A
- US 6753526 A
- US 6924485 A
- EP 0902484 A2
- FR 2752299